# EUROPEAN PATENT APPLICATION

(11) **EP 1 049 160 A1**
(43) Date of publication of application: **02.11.2000**
(21) Application number: 00108501.8
(22) Date of filing: 19.04.2000
(51) Int. Cl.: H01L 21/8239, H01L 29/417, H01L 21/768, H01L 27/115

(54) **New contact shape for giga scale borderless contacts and method for making the same**

(30) Priority: 26.04.1999 US 299134
(71) Applicant: International Business Machines Corporation, Armonk, NY 10504 (US); Siemens Aktiengesellschaft, 80506 München (DE)
(72) Inventor: Dobuzinsky, David M., Hopewell Junction, NY 12533 (US); Lu, Zhijian, Poughkeepsie, NY 12603 (US); Rupp, Thomas S., Stormville, NY 12582 (US)
(74) Representative: Teufel, Fritz, Dipl.-Phys.

(57) **Abstract**

A borderless contact for giga-scale groundrule is widened perpendicular to the wordline direction (parallel to the MO metal line) resulting in improvements in all process steps. This is accomplished by making an otherwise square borderless contact structure into a rectangular structure.
Process misalignments are mitigated, and contact resistance is lowered and kept uniform. The maximum allowable contact area is available even under misalignment configurations.

## Description

### Background Of The Invention

### 1. Field of the Invention

This invention relates to the fabrication of integrated circuit devices and, more particularly, to a borderless contact structure and its method of manufacture.

### 2. Description of Related Art

The formation of electrical contacts where lithographic overlay tolerances must be allowed have caused shorting between the contacts and adjacent structures. Borders were introduced to compensate for the inability to precisely align a contact mask with the device areas in order to open contact holes through an insulating layer. The borders ensure that the contact openings will never extend beyond the structure or the regions with which contact is made. However, these borders reduce the available space on the substrate and limit the number of cells or integrated circuits. Thus, borderless contact structures have been employed in order to permit more cells per chip.

Borderless contacts do not require a border around a contact. A borderless contact is a contact which overlies and exposes the active and isolation regions, and gates of the semiconductor device, usually for the purpose of making contact to a diffusion region formed in the substrate. The contacts are always borderless to the gates, but may be only partially borderless to the active regions under misalignment conditions. The contacts are typically formed in a manner which avoids shorting of the diffused junctions to adjacent structures without being limited by lithographic overlay tolerances.

Current state of the art has concentrated on methods of fabricating borderless contacts such that only the desired regions are exposed and other regions remained covered or protected. In U.S. Patent No. 4,944,682 issued to Cronin, et al., on 31 July 1990, entitled, "METHOD OF FORMING BORDERLESS CONTACTS," semiconductor device components are formed wherein there are at least two exposed conducting regions having passivating material overlying these regions. An electrical conducting material then covers the region, and all are subjected to a given etchant. Only those regions having the passivating material not covered with the etch resistant material are removed.

Previous methods of fabricating microelectronic devices have emphasized a reduction in parasitic capacitance and resistance through different contact formations between the junctions of semiconductor transistors. Junction capacitance can be reduced by decreasing the area of the source and drain regions. Junction resistance can be reduced by better alignment of the contacts so that they extend close to the channel region.

For a borderless array contact of a gigabit ground rule device, the process window for lithographic and etch techniques is critical to the manufacture of integrated circuits. Fabrication issues involving overlay requirements, areal image improvements, reduced etch stop, reduced aspect ratio, improved contact resistance, and increased process windowing, remain technical challenges for a gigabit groundrule process.

Bearing in mind the problems and deficiencies of the prior art, it is therefore an object of the present invention to provide a semiconductor device having a more consistent maximum allowable contact area adapted to shrinking ground rule dimensions with a more stable contact resistance.

It is another object of the present invention to provide a contact shape for improved giga scale borderless contacts.

A further object of the invention is to provide a borderless contact array for increasing the lithographic process window.

It is yet another object of the present invention to provide a borderless contact that can compensate for process variations causing misalignment.

Still other advantages of the invention will in part be obvious and will in part be apparent from the specification.

### Summary of the Invention

The above and other objects and advantages, which will be apparent to one of skill in the art, are achieved in the present invention which is directed to, in a first aspect, a semiconductor device comprising: a substrate; at least one conductor and at least one isolation region on the substrate; at least one active area overlapping the at least one conductor; and a borderless contact structure contacting the active area, the borderless contact structure comprising: a lower portion in contact with the active area, the lower portion defined by a spacing between the at least one conductor and by the at least one isolation region; and an upper portion disposed over the conductors having length and width dimensions, the length to width dimension having a greater ratio than about one wherein the length is in a direction substantially perpendicular to the at least one conductors.

In a second aspect, the present invention is directed to a semiconductor device comprising: a substrate; an active area and a bit line conductor having a direction of elongation, on the substrate; at least two gate structures; and a borderless contact structure contacting the active area, the borderless contact having a lower section where contact is made with the active area and an upper section parallel with the active area, wherein the upper section has substantially orthogonal major and minor axes, the major axis being substantially aligned with the direction of elongation of the bit line conductor and the major to minor axes has a ratio greater than about one.

The present invention is directed to, in a third aspect, a method of forming a contact in a semiconductor device having a plurality of gate structures and bitlines with minimal ground rule dimensions disposed on the semiconductor substrate comprising the steps of: forming spacers on vertical surfaces of the plurality of gate structures; depositing a conformal layer of dielectric over the substrate and the plurality of gate structures; aligning and etching a plurality of trenches into the dielectric exposing the substrate between the plurality of gate structures; and forming a contact by depositing a conductive material into the trench, the contact having a lower portion in contact with the substrate, and an upper portion in contact with the dielectric, the upper portion having a first side and a second side, the first side being greater than the second side in a direction parallel to the bitlines.

In a fourth aspect, the present invention is directed to a method of fabricating a semiconductor device having consistent maximum allowable contact areas comprising the steps of: providing a substrate having a plurality of gates and bitlines; the gates forming at least two word lines; forming spacers on vertical walls of the at least two word lines; depositing a conformal layer of dielectric over the substrate; etching a contact area in the dielectric in alignment with the at least two word lines such that a portion of the substrate between the at least two word lines is exposed, the contact area having a lower portion, the lower portion in contact with the substrate, and an upper portion, the upper portion in contact with a top surface of the at least two word lines and the dielectric and having a width and a length, the length being greater than the width by a factor of greater than one in a direction parallel to the bitlines; depositing a conductive material into the contact area to form a contact having lower and upper sections.

In a fifth aspect, the present invention is directed to a semiconductor device comprising: a substrate; at least one conductor, at least one bitline, and at least one isolation region on the substrate; at least one active area overlapping the at least one conductor; and a self-aligned borderless contact structure contacting the active area, the borderless contact structure comprising: a lower portion in contact with the active area, the lower portion defined by a spacing between the at least one conductor and by the at least one isolation region; and an upper portion disposed over the conductors having length and width dimensions, the length to width dimension having a greater ratio than about one wherein the length is in a direction substantially parallel to the at least one bitline.

### Brief Description of the Drawings

The features of the invention believed to be novel and the elements characteristic of the invention are set forth with particularity in the appended claims. The figures are for illustration purposes only and are not drawn to scale. The invention itself, however, both as to organization and method of operation, may best be understood by reference to the detailed description which follows taken in conjunction with the accompanying drawings in which:
Fig. 1A is a top view of a semiconductor device having a conventional contact array.
Fig. 1B is a top view of a semiconductor device having a rectangular borderless contact structure.
Fig. 2 depicts the cross-section of a semiconductor device with gate structures and deep trench capacitors.
Fig. 3 depicts the cross-section of a semiconductor device of Fig. 2 with an oxide dielectric deposition on the surface.
Fig. 4A depicts the cross-section of a semiconductor device of Fig. 3 with a photoresist applied and an etched column for a properly aligned contact to gate.
Fig. 4B is a cross-section of a semiconductor device having an etched column that is misaligned between two gate structures.
Fig. 5 is a cross-section of a semiconductor device having the misalignment shown in Fig. 4B, but with a rectangular borderless contact allowing for maximum contact area.
Fig. 6 is a cross-section of the semiconductor device of Fig. 5 having an etched column for a rectangular contact that is properly aligned between two gate structures.
Fig. 7 is a cross-section of the semiconductor device of Fig. 6 having a metal line deposited in an etched trench and an etched column.

### Description of the Preferred Embodiment(s)

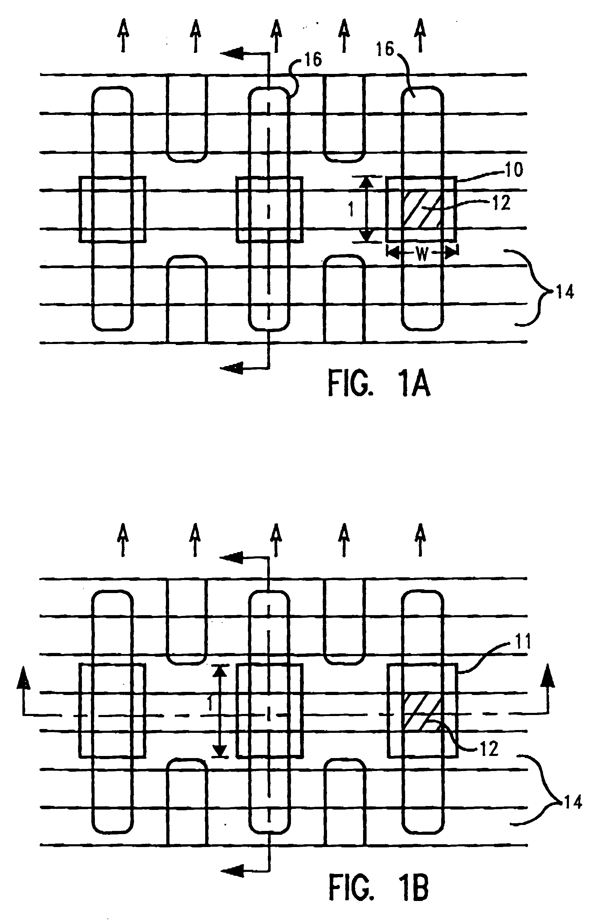

In describing the preferred embodiment of the present invention, reference will be made herein to Figs. 1-7 of the drawings in which like numerals refer to like features of the invention. Features of the invention are not necessarily shown to scale in the drawings.

A widening of the contact perpendicular to the wordline direction (parallel to the MO metal line) results in improvements in all process steps. This is accomplished by making an otherwise square borderless contact structure into a rectangular structure. Figure 1A depicts a conventional contact array having a square borderless contact 10 with contact area 12. The contact connects diffusion regions (drain and source regions of a field effect transistor) to metal bitlines 16. The footprint of the square contact has length (l) and width (w) dimensions typically on the order of 0.225 micrometers (for a 0.175 m ground rule). This poses lithographic and alignment problems commonly associated with these small dimensions. In the placement of the borderless contact structure, a more or less perpendicular configuration of active area and wordline as well as wordline to the first metal line is assumed. Fig. 1B depicts the rectangular borderless contact structure 11 of the instant invention. One dimension (l) of the contact structure has been increased. Preferably, this dimension is increased to approximately 0.350 µm (for a 0.175 µm ground rule). The contact is widened either in the direction perpendicular to the wordline 14 or parallel to the bitline 16. This approach was not attempted in the prior art due to the shorting of the bitlines by the increased contact size. Significantly, a simple widening of the contact size, i.e., a larger square contact, does not suffice as a result of possible shorting.

Actual integration schemes for current borderless contacts are then employed. The dimension changes can be easily implemented by changing one mask. These changes have no impact on bitline-to-bitline shorts yield. For a lithography process, the wider contact area and larger size of the borderless contact in one dimension results in a better areal image, and importantly, in a wider lithographic process window. The new contact area (for a 0.175 µm ground rule) is on the order of 0.0788 µm² (0.350 µm x 0.225 µm), whereas the prior art contacts, with square contact shapes, have a footprint area of approximately 0.0506 µm² (0.225 µm x 0.225 µm). Thus, making a borderless contact with a major and minor axis, such that the major to minor axis ratio is greater than one, i.e., a contact rectangular or oval in shape, results in approximately a 56% increase in contact area under normal process variations.

The shrinkage of the overlay specification with shrinking design rule also remains a challenge for current lithographic tools. Typically the overlay specification is approximately three to four tenths of the design rule. Meeting this overlay specification is extremely critical to contact resistance and etch. In order to meet the overlay specification, especially in the direction perpendicular to the gates or wordline or parallel to the bitlines, an increase in the contact size in the bitline direction is adopted. This ensures that the whole available active area between the wordline is utilized, and that the contact is bordered by gates on both sides.

For borderless contacts, selective etching is the process that is preferably used to ensure the contact is truly bordered by the gates on two opposite sides of the contact, and by the isolation regions on the other adjacent sides. The gates are typically isolated with a silicon nitride cap and spacer. Important to this process, the RIE etch must progress down more in the middle of the gates than on each gate edge. An etch that is at the border or edge of the gate, between spacer and gate, or at the edge of the spacer, runs a higher risk of wordline-bitline shorting, i.e., there is reduced corner selectivity. If the etching process results in an etched column that is on top of or beside the spacer, a higher etch rate results, requiring more spacer removal and higher stud to wordline capacity. Thus, the needed overlap of contact and wordline can be achieved with a wider contact, since the overlap of contact and gates is optimized and not reduced with shrinking groundrule and contact size. Similarly, with an increased contact size and reduced aspect ratio, the contact fill will be greatly facilitated. Also, the contact resistance between the metal line and the stud is considerably reduced due to the gain in contact size between the metal line and the stud. A more stable contact resistance is realized due to the inherent 100% usage of the available active area.

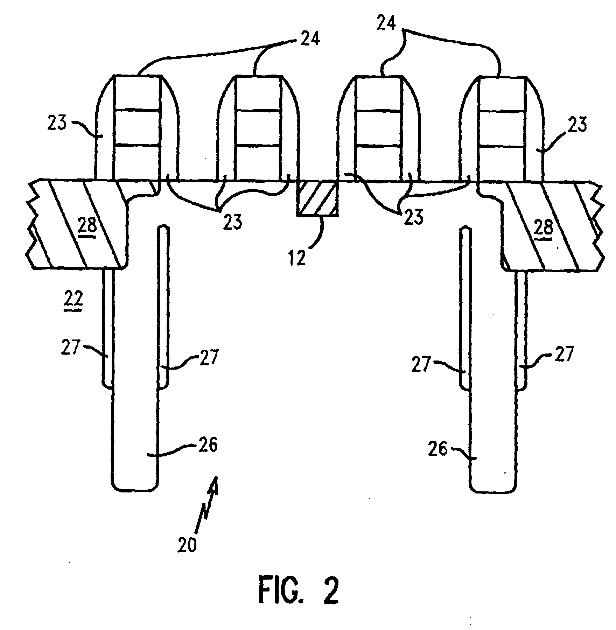

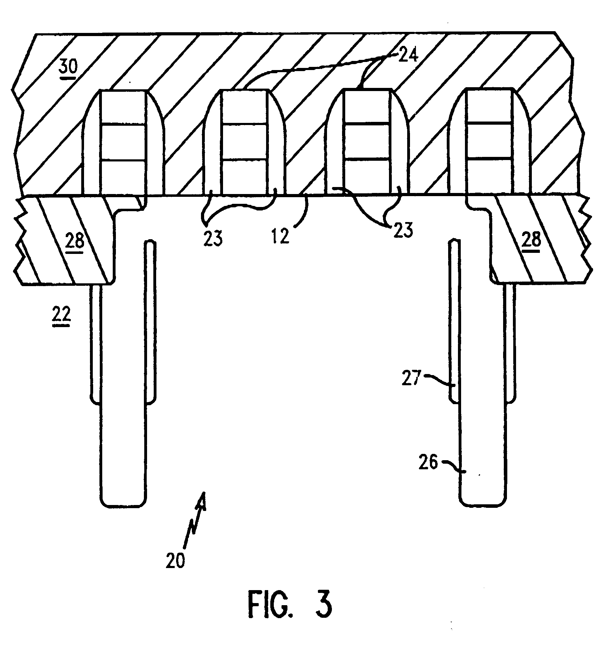

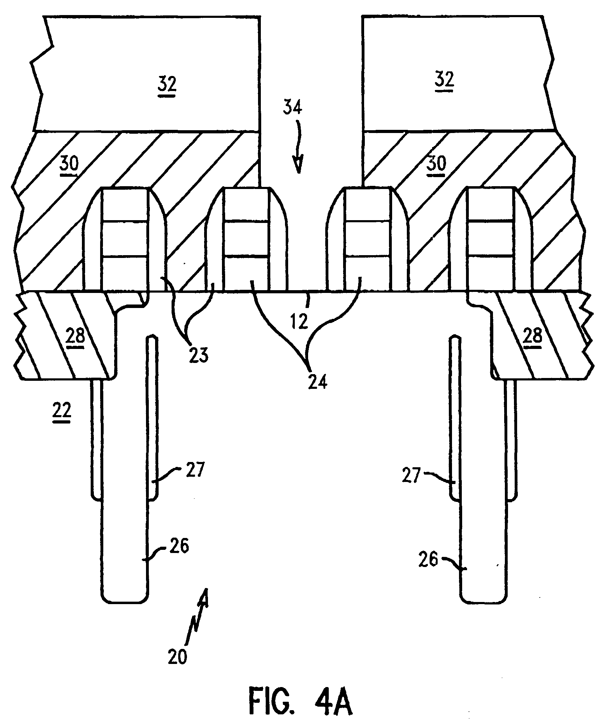

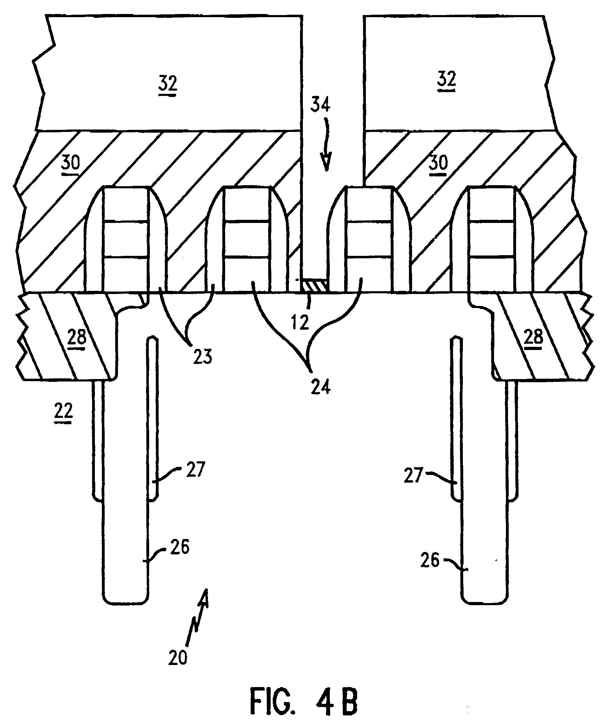

Fig. 2 depicts the cross-section of a semiconductor device 20 having a silicon substrate 22 with gate structures 24, silicon nitride spacers 23, and deep trench capacitors 26. The deep trench capacitors are isolated by oxide collars 27. The maximum available contact area 12 is shown between two silicon nitride gate structures (wordlines). Two gate structures are shown over shallow trench isolation barriers 28. An oxide dielectric 30 is then deposited on the semiconductor device 20, as shown in Fig. 3. Figure 4A shows this oxide dielectric layer 30 having a photoresist applied 32, and subjected to a lithographic and etching process. The removal of the dielectric layer forms an etched column 34 that is desirably centered between two gate structures 24, thus exposing the maximum allowable contact area 12. However, in many instances, due to the small contact tolerances and inherent process limitations, misalignment of the etch column remains a problem in the art. This makes centering of the etched column very difficult to achieve under the current process limitations. Fig. 4B depicts a typical misalignment of the etch column in this process.

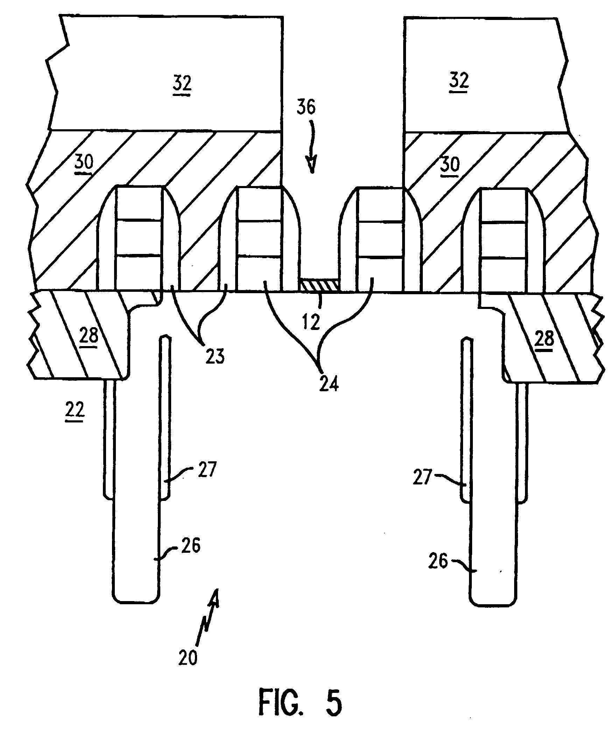

As shown in Fig. 5, under a misalignment configuration, a wider etch column 36 will still expose the maximum allowable contact area 12 for the borderless contact. Thus, having a rectangular borderless contact ensures maximum contact area exposure during processing, even under misalignment conditions.

Again, adapting the prior art application to larger square borderless contact structures is not an acceptable solution because of the bitline and wordline shorting that would occur.

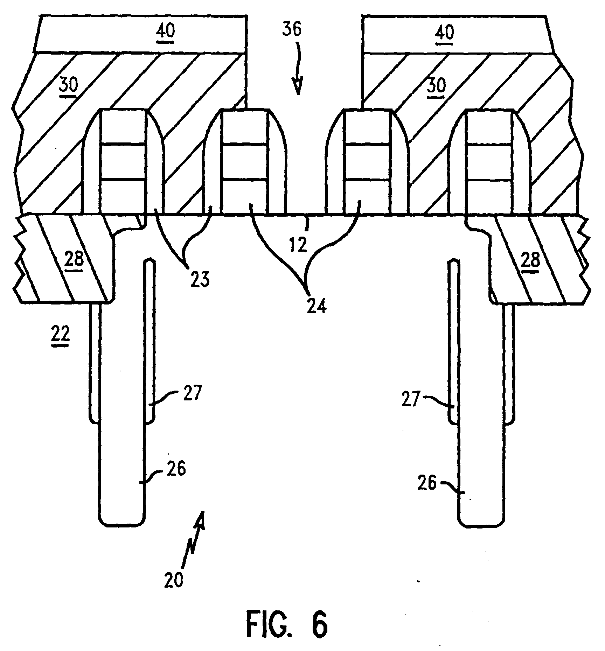

When this process is implemented for rectangular borderless contacts (where the contact is wider in one dimension), it is more accommodating of structure tolerances and process deviations. As indicated in Fig. 6, a wider etch column 36 is used to clear the way for the contact deposition layer. This wider column compensates for tight tolerance misalignments that are prevalent in the prior art. Additionally, a trench 40 is created for metal line deposition.

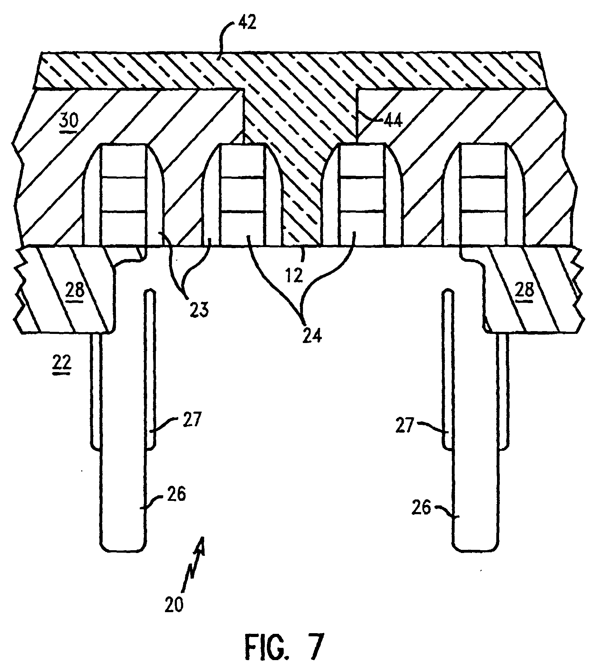

Once the photoresist for the bitline has been removed, a metal line 42 and contact 44 is deposited by the damascene process as shown in Fig. 7. Preferably, this deposited metal structure is a tungsten material. Importantly, the entire contact area 12 is now capable of being attached to contact 44 in a misalignment configuration.

The rectangular borderless contact is defined above for an xide isolation structure with etching oxide selective to nitrides. However, a complementary etch process or other selective etch process may be used, i.e., etching nitrides instead of oxides.

A rectangular borderless contact structure capable of maintaining consistent maximum allowable contact area during process misalignments is introduced, along with the method for making the structure.

While the present invention has been particularly described, in conjunction with a specific preferred embodiment, it is evident that many alternatives, modifications and variations will be apparent to those skilled in the art in light of the foregoing description. It is therefore contemplated that the appended claims will embrace any such alternatives, modifications and variations as falling within the true scope and spirit of the present invention.

## Claims

1. A semiconductor device comprising:
a substrate;
at least one conductor and at least one isolation region on said substrate;
at least one active area overlapping said at least one conductor; and
a borderless contact structure contacting said active area, said borderless contact structure comprising:
(i) a lower portion in contact with said active area, said lower portion defined by a spacing between said at least one conductor and by said at least one isolation region; and
(ii an upper portion disposed over said conductors having length and width dimensions, the length to width dimension having a greater ratio than about one wherein the length is in a direction substantially perpendicular to said at least one conductor.

2. The semiconductor device of claim 1 further including a conductive line in electrical connection with said contact structure.

3. The semiconductor device of claim 1 wherein said at least two conductors comprise word lines.

4. The semiconductor device of claim 3 wherein said word lines comprise gate structures.

5. The semiconductor device of claim 1 wherein said at least two conductors comprise bit lines.

6. The semiconductor device of claim 1 wherein said contact structure comprises tungsten.

7. The semiconductor device of claim 1 wherein said contact structure comprises polysilicon.

8. The semiconductor device of claim 1 further including dielectric spacers within said spacing between said at least two conductors.

9. The semiconductor device of claim 8 wherein said spacers comprise silicon nitride.

10. The semiconductor device of claim 1 wherein said contact structure electrically connects a substrate of said device to a metal line.

11. A semiconductor device comprising:
a substrate;
an active area and a bit line conductor having a direction of elongation, on said substrate;
at least two gate structures; and
a borderless contact structure contacting said active area, said borderless contact having a lower section where contact is made with said active area and an upper section parallel with said active area, wherein said upper section has substantially orthogonal major and minor axes, said major axis being substantially aligned with the direction of elongation of said bit line conductor and said major to minor axes has a ratio greater than about one.

12. The semiconductor device of claim 11 wherein said upper portion of said contact structure may be misaligned along said major axis between said at least two device structures while said lower portion is in contact with an entire surface of said active area.

13. A method of forming a contact in a semiconductor device having a plurality of gate structures and bitlines with minimal ground rule dimensions disposed on said semiconductor substrate comprising the steps of:
(a) forming spacers on vertical surfaces of the plurality of gate structures;
(b) depositing a conformal layer of dielectric over the substrate and the plurality of gate structures;
(c) aligning and etching a plurality of trenches into said dielectric exposing the substrate between the plurality of gate structures; and
(d) forming a contact by depositing a conductive material into said trench, said contact having a lower portion in contact with the substrate, and an upper portion in contact with said dielectric, said upper portion having a first side and a second side, said first side being greater than said second side in a direction parallel to said bitlines.

14. The method of claim 13 further including the step of depositing a metal liner into said trench prior to step (d).

15. The method of claim 13 wherein a dimension of said first side to a dimension of said second side has a ratio greater than about one.

16. A method of fabricating a semiconductor device having consistent maximum allowable contact areas comprising the steps of:
(a) providing a substrate having a plurality of gates and bitlines; said gates forming at least two word lines;
(b) forming spacers on vertical walls of said at least two word lines;
(c) depositing a conformal layer of dielectric over said substrate;
(d) etching a contact area in said dielectric in alignment with said at least two word lines such that a portion of said substrate between said at least two word lines is exposed, said contact area having a lower portion, the lower portion in contact with said substrate, and an upper portion, the upper portion in contact with a top surface of said at least two word lines and said dielectric and having a width and a length, said length being greater than said width by a factor of greater than one in a direction parallel to said bitlines;
(e) depositing a conductive material into said contact area to form a contact having lower and upper sections.

17. The method of claim 16 wherein the upper section of said contact can substantially correct misalignment of said contact area in a direction perpendicular to said word lines during step (d) such that an entire area of said substrate between said at least two word lines forms the lower section of said contact.

18. The method of claim 16 wherein in step (b) said spacers comprise silicon nitride.

19. The method of claim 16 wherein step (e) further includes the step of depositing a liner metal into said contact area followed by depositing tungsten into said contact area to form said contact.

20. The method of claim 16 wherein step (e) further includes the step of depositing a liner metal into said contact area followed by polysilicon into said contact area to form said contact.

21. The method of claim 16 wherein in step (c) said dielectric comprises silicon oxide.

22. A semiconductor device comprising:
a substrate;
at least one conductor, at least one bitline, and at least one isolation region on said substrate;
at least one active area between said at least one conductor; and
a self-aligned borderless contact structure contacting said active area, said borderless contact structure comprising:
(i) a lower portion in contact with said active area, said lower portion defined by a spacing between said at least one conductor and by said at least one isolation region; and
(ii) an upper portion disposed over said conductors having length and width dimensions, the length to width dimension having a greater ratio than about one wherein the length is in a direction substantially parallel to said at least one bitline.
